# EUROPEAN PATENT APPLICATION

(11) **EP 4 770 378 A1**
(43) Date of publication of application: **01.07.2026**
(21) Application number: 25206105.6
(22) Date of filing: 01.10.2025
(51) Int. Cl.: H10K 59/131, H10K 59/124, H10D 86/40, H10D 86/60

(54) **DISPLAY DEVICE**

(30) Priority: 27.12.2024 KR 20240198532
(71) Applicant: LG Display Co., Ltd., Seoul, 07336 (KR)
(72) Inventor: LEE, Seung-Hyun, 10845 Gyeonggi-do (KR)
(74) Representative: Ter Meer Steinmeister & Partner

(57) **Abstract**

A display device in some examples includes a first area, a second area, gate lines arranged in a first direction in the first and second areas, first data lines arranged in a second direction perpendicular to the first direction in the first area, second data lines arranged in the second direction in the second area and having a length shorter than a length of the first data lines, vertical link lines arranged in the second direction in the first area, and horizontal link lines arranged in the first direction in the first and second areas. Each of the vertical link lines is electrically connected to the corresponding one second data line through the corresponding one horizontal link line, and each of the vertical link lines has a length inversely proportional to a length of the second data lines to be connected.

## Description

This application claims priority to Korean Patent Application No. 10-2024-0198532, filed in the Republic of Korea on December 27, 2024.

### BACKGROUND

### 1. Technical Field

The present disclosure relates to a display device, and more particularly to, a display device with a minimal bezel area and capable of compensating easily storage capacity.

### 2. Description of Related Art

As information technologies have developed, a field of display devices displaying information has been developed rapidly, and various display devices with beneficial performances such as thinning, lightening, and low power consumption are being developed.

Link lines for applying various signals to a display area are arranged in outside of the display area where images are displayed in such display devices. The link lines are a major cause of increasing a bezel area of the display device.

The description of related art should not be considered prior art merely because it is mentioned in or associated with this section. The description of related art includes information that describes one or more aspects of the subject technology, and the description in this section does not limit the scope of the invention.

### SUMMARY

Accordingly, one or more embodiments of the present disclosure are directed to a display device that substantially obviates one or more of the problems due to the limitations and disadvantages of the related art.

It is an object to provide a display device capable of preventing image quality deterioration by compensating for variations in storage capacity due to a free form or an irregular shape.

It is another object to provide a display device capable of minimizing a bezel area by disposing a correcting component for correcting a deviation in storage capacity in a display area.

Additional features and aspects will be set forth in the description that follows, and in part will be apparent from the description, or can be learned by practice of the disclosed concepts provided herein. Other features and aspects of the disclosed concept can be realized and attained by the structure particularly pointed out in the written description, or derivable therefrom, and the claims hereof as well as the appended drawings.

The object is solved by the features of the independent claim preferred embodiments are given in the dependent claims

To achieve these and other aspects of the inventive concepts, as embodied and broadly described, in one aspect, the present disclosure provides a display device that comprises a display panel including a first area and at least one second area; a plurality of gate lines arranged in a first direction in the first area and the at least one second area; a plurality of first data lines arranged in a second direction perpendicular to the first direction in the first area; a plurality of second data lines arranged in the second direction in the at least one second area and having a length shorter than a length of the plurality of first data lines; a plurality of vertical link lines arranged in the second direction in the first area; and a plurality of horizontal link lines arranged in the first direction in the first area and the at least one second area, wherein each of the plurality of vertical link lines is electrically connected to a corresponding one second data line through a corresponding one horizontal link line, and each of the plurality of vertical link lines has a length inversely proportional to a length of a respective one of the plurality of second data lines to be connected.

**In** one or more embodiments, a data signal can be directly applied to each of the plurality of first data lines, and the data signal can be applied to each of the plurality of second data lines through the a respective one of the plurality vertical link lines and a respective one of the plurality of the horizontal link lines.

**In** one or more embodiments, the display device may further include: a first contact hole electrically connecting each of the plurality of vertical link lines to the corresponding one horizontal link line; and a second contact hole electrically connecting each of the plurality of horizontal link lines to the corresponding one second data line.

**In** one or more embodiments, the display device may further include: a thin film transistor disposed in the first area and the at least one second area, respectively; and a light emitting diode disposed on the thin film transistor.

**In** one or more embodiments, the thin film transistor may include: a semiconductor layer disposed on a substrate; a gate electrode disposed on the semiconductor layer; and a source electrode and a drain electrode disposed on the gate electrode.

**In** one or more embodiments, the display device may further include: a gate insulating layer disposed between the semiconductor layer and the gate electrode; an interlayer insulating layer disposed between the gate electrode, and the source electrode and the drain electrode; a planarization layer disposed on the source electrode and the drain electrode; and a connection pattern disposed on the planarization layer and connected to one of the source electrode and the drain electrode.

In one or more embodiments, the plurality of vertical link lines can be arranged on a planarization layer, the plurality of horizontal link lines can be arranged on an interlayer insulating layer.

**In** one or more embodiments, the plurality of vertical link lines can comprise a same material as the connection pattern.

**In** one or more embodiments, the plurality of horizontal link lines can comprise a same material as the source electrode and the drain electrode.

**In** one or more embodiments, each of the plurality of vertical link lines can be electrically connected to the corresponding one horizontal link line through the first contact hole disposed in the planarization layer.

**In** one or more embodiments, each of the plurality of vertical link lines may extend a predetermined distance from the first contact hole, and the predetermined distance of each of the plurality of vertical link lines may be inversely proportional to the length of the respective one of the second data lines to be connected.

**In** one or more embodiments, a distance between the plurality of horizontal link lines connected to the plurality of second data lines may increase as the length of the second data lines decreases.

The display panel may have a free form.

The first area may be a rectangular-shaped area, and the at least one second area may be a non-rectangular-shaped area.

The display panel may have a circular shape.

The first area may be a central area of the circular shape and the at least one second area may be both side areas of the central area.

The plurality of vertical link lines may be not arranged in the second area.

The plurality of first data lines may be formed to have a same length.

In another aspect, the present disclosure provides a display device that comprises a display panel including a first area and at least one second area; a plurality of gate lines arranged in a first direction in the first area and the at least one second area; a plurality of first data lines arranged in a second direction perpendicular to the first direction in the first area; a plurality of second data lines arranged in the at least one second direction in the second area and having a length shorter than a length of the plurality of first data lines; a plurality of vertical link lines arranged in the second direction in the first area; a plurality of horizontal link lines arranged in the first direction in the first area and the at least one second area; and a plurality of compensation link lines extended from the plurality of vertical link lines, respectively, wherein each of the plurality of vertical link lines is electrically connected to a corresponding one second data line through a corresponding one horizontal link line, and each of the plurality of compensation link lines has a length inversely proportional to a length of a respective one of the plurality of second data lines to be connected.

In another aspect, the present disclosure provides a display device that comprises a display panel including a first area and at least one second area; a plurality of gate lines arranged in a first direction in the first area and the at least one second area; a plurality of first data lines arranged in a second direction perpendicular to the first direction in the first area; a plurality of second data lines arranged in the second direction in the at least one second area and having a length shorter than a length of the plurality of first data lines; a plurality of vertical link lines arranged in the second direction in the first area; and a plurality of horizontal link lines arranged in the first direction in the first area and the at least one second area, wherein a distance between the plurality of horizontal link lines is inversely proportional to a length of a respective one of the plurality of second data lines to which a respective one of the plurality of horizontal link lines are connected.

In one or more embodiments, it is possible to prevent image quality from being deteriorated by compensating for a difference in storage capacity due to a difference in length of data lines disposed in a free-form or an irregular area in the display device.

Also, the display device can minimize its bezel area by disposing a correction pattern for correcting the deviance of storage capacity in the display area.

Since the deviation of the storage capacity is corrected to prevent image quality deterioration, it is possible to realize low power due to high efficiency.

It is to be understood that both the foregoing general description and the following detailed description are examples and explanatory, and are intended to provide further explanation of the inventive concepts as claimed.

### BRIEF DESCRIPTION OF THE DRAWINGS

The accompanying drawings, which provide a further understanding of the disclosure, are incorporated in and constitute a part of this application, illustrate embodiments of the disclosure and together with the description serve to explain principles of the disclosure.
FIG. 1 illustrates a schematic block diagram of a display device in accordance with one or more embodiments of the present disclosure.
FIG. 2 illustrates a schematic block diagram of a sub-pixel in the display device in accordance with one or more embodiments of the present disclosure.
FIG. 3 illustrates a schematic circuit diagram of a sub-pixel in the display device in accordance with one or more embodiments of the present disclosure.
FIG. 4 illustrates a schematic plane view of a display device in accordance with one embodiment of the present disclosure.
FIG. 5 illustrates line arrangements in the display area of the display device in accordance with one embodiment of the present disclosure.
FIG. 6A illustrates a schematic cross-sectional view of the display device taken along a line I-I' in FIG. 4.
FIG. 6B illustrates a schematic cross-sectional view of the display device taken along a line II-II' in FIG. 5.
FIG. 7 illustrates line arrangements in the display area of the display device in accordance with another embodiment of the present disclosure.

### DETAILED DESCRIPTION

Advantages and features of the present disclosure and methods for achieving them will be made clear from embodiments described in detail below with reference to the accompanying drawings. The present disclosure can, however, be implemented in many different forms and should not be construed as being limited to the embodiments set forth herein, and the embodiments are provided such that this disclosure will be thorough and complete and will fully convey the scope of the present disclosure to those skilled in the art to which the present disclosure pertains.

Shapes, sizes, ratios, angles, numbers, and the like disclosed in the drawings for describing embodiments of the present disclosure are merely illustrative examples, and thus the present disclosure is not limited to the illustrated examples. The same reference numerals refer to the same components throughout this disclosure unless otherwise specified. Further, in the following description of the present disclosure, where a detailed description of a known related art may unnecessarily obscure the gist of the present disclosure, the detailed description thereof may be omitted herein or may be briefly discussed.

Where terms such as "including," "having," "comprising," and the like are used in this disclosure, other parts can be added unless a more limiting term like "only" is used herein. Further, where a component is expressed as being singular, being plural is included, and vice versa, unless otherwise specified. For example, an element may be one or more elements. An element may include a plurality of elements. The word "exemplary" is used to mean serving as an example or illustration. Embodiments are example embodiments. Aspects are example aspects. In one or more implementations, "embodiments," "examples," "aspects," and the like should not be construed to be preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

In analyzing a component, an error range should be interpreted as being included even where there is no explicit description.

In describing a positional relationship, for example, where a positional relationship of two parts/layers is described as being "over," "on," "above," "below," "under," "next to," or the like, one or more other parts/layers can be provided between the two parts/layers, unless a more limiting term like "immediately" or "directly" is used therewith.

In describing a temporal relationship, for example, where a temporal predecessor relationship is described as being "after," "subsequent," "next to," "prior to," or the like, unless a more limiting term like "immediately" or "directly" is used, cases that are not continuous or sequential can also be included.

Although the terms first, second, and the like may be used to describe various components, these components are not substantially limited by these terms. These terms are used only to refer to one component separately from another component, and may not define any particular order or sequence. Therefore, a first component described below can substantially be a second component, and vice versa, within the technical concept of the present disclosure.

In describing components of the present disclosure, terms such as first, second, A, B, (a), (b), etc. may be used. These terms are only intended to distinguish the components from other components, and the nature, order, sequence, or numbers of the components are not limited by the terms. When it is described that a component is "connected," "coupled," or "adhered" to another component, it should be understood that the component may be directly "connected," "coupled," or "adhered" to the other component, but that other components may also be "interposed" between each component, or that each component may be "connected," "coupled," or "adhered" through another component.

Features of various embodiments of the present disclosure can be partially or entirely united or combined with each other, technically various interlocking and driving are possible, and each of the embodiments can be independently implemented with respect to each other or implemented together in a co-dependent relationship.

All the components of each display device according to all embodiments of the present disclosure are operatively coupled and configured.

As used herein, "display device" can comprise a narrowly defined display device such as a display module including a display panel and a driving unit for driving the display panel. In addition, the display device can also include a set electronic device or a set apparatus such as a notebook computer, a television, a computer monitor, an automotive display, or other forms of a vehicle, which are complete products (or final products) including a display module, an equipment display, a mobile electronic device such as a smart phone or an electronic pad, and the like.

Therefore, the display device in the present disclosure can include a narrowly defined display device itself such as a display module, and a set apparatus which is an application product or a final consumer device including a display module.

The present disclosure can be applied to various display devices. For example, the disclosure can be applied to an organic light-emitting display device, a liquid crystal display device, an electrophoretic display device, a quantum-dot display device, a micro light-emitting diode (LED) display device, a mini LED display device. For the convenience of explanation, the organic light-emitting display device as an example of the display device can be described. However, the present disclosure is not limited to the organic light-emitting display device.

Reference will now be made in detail to aspects of the disclosure, examples of which are illustrated in the accompanying drawings. Wherever possible, the same reference numbers will be used throughout the drawings to refer to the same or like parts.

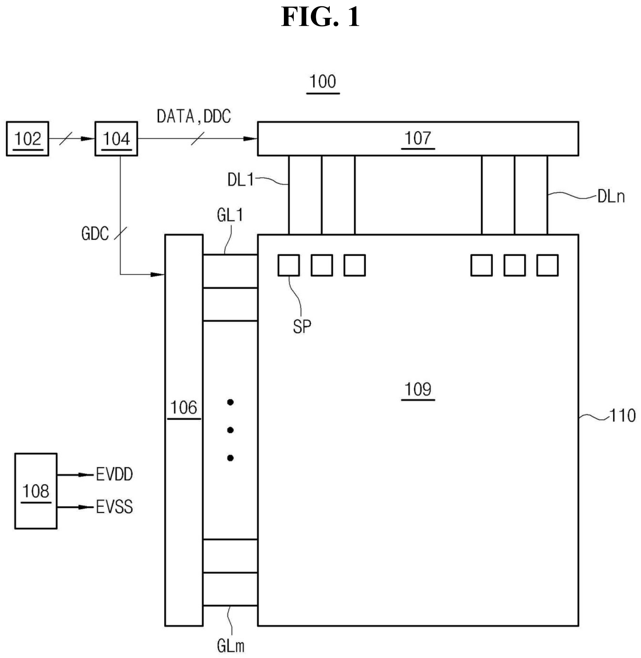

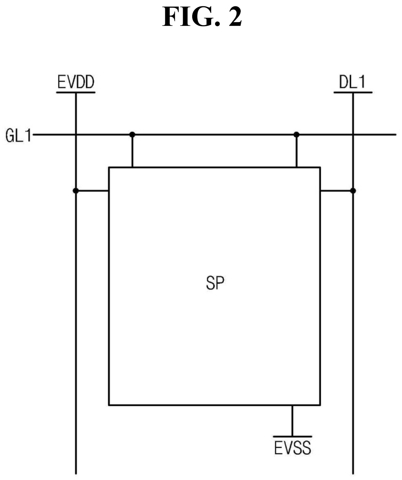

FIG. 1 illustrates a schematic block diagram of a display device in accordance with the present disclosure. FIG. 2 illustrates a schematic block diagram of a sub-pixel in the display device in accordance with the present disclosure.

Referring FIG. 1, a display device 100 can comprise an image processor 102, a timing controller 104, a gate driver 106, a data driver 107, a power supplier 108 and a display panel 109.

The image processor 102 outputs driving signals for driving various components together with an image data supplied from outside. For example, the driving signal output form the image processor 102 can comprise, but is not limited to, a data enable signal, a vertical synchronization signal, a horizontal synchronization signal, a clock signal, and the like.

The timing controller 104 receives driving signals along with the image data from the image processor 102. The timing controller 104 generates and outputs a gate timing control signal GDC for controlling an operation timing of the gate driver 106 and a data timing control signal DDC for controlling an operation timing of the data driver 107 based on the driving signal input from the image processor 102.

The gate driver 106 outputs a scan signal to the display panel 109 in response of the gate timing control signal GDC supplied from the timing controller 104. The gate driver 106 outputs the scan signal though a plurality of gate lines GL1 to GLm (m is an integer equal to or greater than 2). In one embodiment, the gate driver 106 can be formed as an integrated circuit (IC), but is not limited thereto. In another embodiment, the gate driver 106 can comprise various gate driving circuits which are directly formed on the display panel 109. In this case, the gate driver 106 can be a GIP (Gate-In-Panel).

The data driver 107 outputs data voltage to the display panel 109 in response of the data timing control signal DDC input from the timing controller 104. The data driver 107 samples and latches a digital-type data signal DATA supplied from the timing controller 104 and convers the digital-type data signal DATA into analog-type data voltage based on a gamma voltage. The data driver 107 outputs the data voltage through a plurality of data lines DL1 to DLn (n is an integer equal to or greater than 2). In one embodiment, the data driver 107 can be formed as an integrated circuit (IC), but is not limited thereto.

The power supplier 108 outputs high-potential voltage and low-potential voltage and supplies high-potential voltage and low-potential voltage to the display panel 109. The high-potential voltage is supplied to the display panel 109 through a first power line EVDD and the low-potential voltage is supplied to the display panel 109 through a second power line EVSS. Alternatively or additionally, the voltages output form the power supplier 108 can be output to the gate driver 106 and/or the data driver 107 for driving those drivers 106 and 107.

The display panel 109 display images in response to the scan signal supplied from the gate driver 106, the data voltage supplied from the data driver 107 and the power supplied from the power supplier 108.

The display panel 109 comprises a plurality of sub-pixels SPs to display an image. In one embodiment, the sub-pixel SP can comprise a red (R) sub-pixel, a green (G) sub-pixel and a blue (B) sub-pixel. Alternatively, the sub-pixel SP can comprise a white (W) sub-pixel, a red (R) sub-pixel, a green (G) sub-pixel and a blue (B) sub-pixel. In one embodiment, the white (W), red (R), green (G) and blue (B) sub-pixels can have a substantially same area. Alternatively, the white (W), red (R), green (G) and blue (B) sub-pixels can have different areas.

Referring to FIG. 2, each sup-pixel SP can be connected to a gate line GL1, a data line DL1, a first power line EVDD and a second power line EVSS. The numbers and driving methods of a transistor and a capacitor can be determined by configuration of the pixel circuit in the sub-pixel SP. For example, the sub-pixel SP can comprise two transistors and one capacitor (2T1C), but is not limited thereto. In another embodiment, the sub-pixel SP can comprise 3T1C, 4T1C, ST1C, 6T1C, 7T1C, 3T2C, 4T2C, 5T2C, 6T2C, 7T2C, 8T2C and the like.

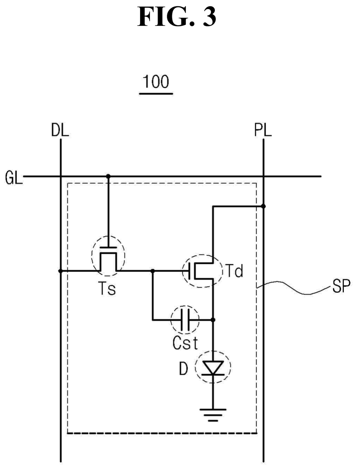

FIG. 3 illustrates a schematic circuit diagram of a sub-pixel in the display device in accordance with the present disclosure.

Referring to FIG. 3, the display device 100 includes a gate line GL, a data line DL and a power line PL crossing each other to define the sub-pixel SP. A switching thin film transistor Ts, a driving thin film transistor Td, a storage capacitor Cst and a light-emitting diode D can be disposed in the sub-pixel SP.

The switching thin film transistor Ts is connected to the gate line GL and the data line DL. The driving thin film transistor Td and the storage capacitor Cst are connected between the switching thin film transistor Ts and the power line PL, and the light-emitting diode D is connected to the driving thin film transistor Td.

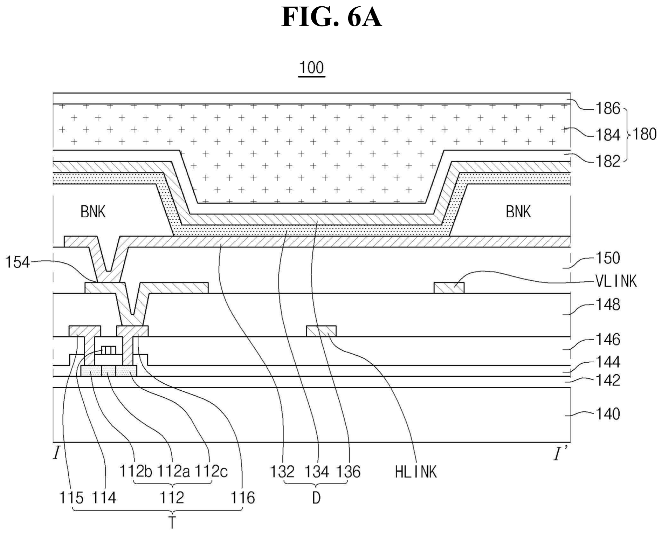

In the display device 100, when the switching thin film transistor Ts is turned on by a gate signal applied to the gate line GL, the data signal applied to the data line DL is applied a gate electrode 114 (FIG. 6A) and one electrode of the storage capacitor Cst through the switching thin film transistor Ts.

The driving thin film transistor Td is turned on by the data signal applied to the gate electrode 114 so that a current proportional to the data signal is supplied from the power line PL to the light-emitting diode D through the driving thin film transistor Td. And then, the light-emitting diode D emits light having a luminance proportional to the current flowing through the driving thin film transistor Td. In this case, the storage capacitor Cst is charged with a voltage proportional to the data signal so that the voltage of the gate electrode 114 in the driving thin film transistor Td is kept constant during one frame. Therefore, the display device 100 can display a desired image.

In FIG. 3, the display device 100 includes two thin film transistors Ts and Td and one storage capacitor Cst in the sub-pixel SD. However, the display device 100 can comprise three or more thin film transistors and two or more storage capacitors in the sub-pixel SP.

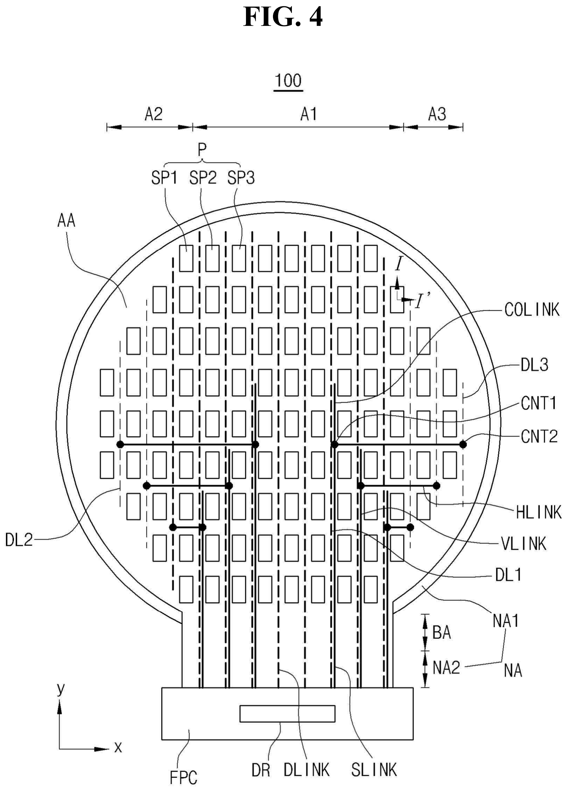

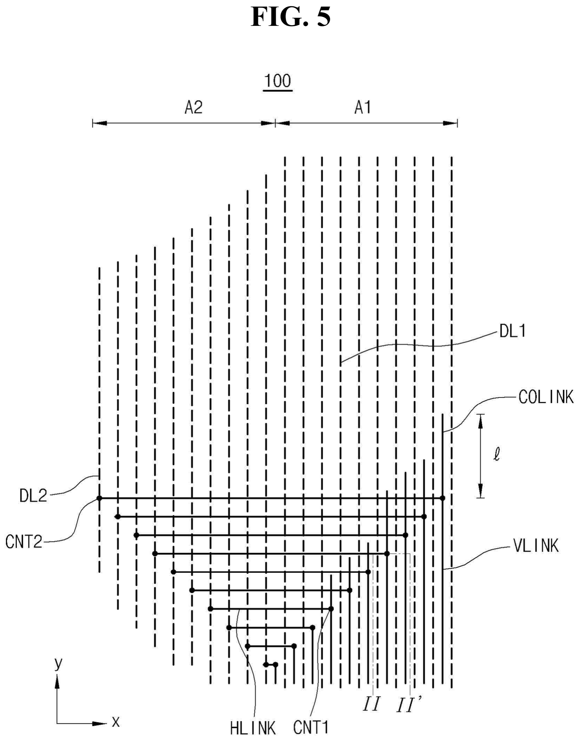

FIG. 4 illustrates a schematic plane view of a display device in accordance with one embodiment of the present disclosure. FIG. 5 illustrates line arrangements in the display area of the display device in accordance with one embodiment of the present disclosure.

In one embodiment, the display device 100 can be applied to a free-form display device, but is not limited thereto. As used herein, the free-form display device can indicates a display device with a non-rectangular shape. For example, the free-form display device can be a non-rectangular shaped display device such as a circular shape, an ellipsoidal shape, a curved shape and an irregular shape, but is not limited thereto.

In one exemplary embodiment, the display device 100 can be the free-form display device that can be applied to various electronic apparatuses such as a watch and/or a dash-board in a vehicle. Hereinafter, the display device 100 with the circular shape will be described in more detail. In another embodiment, the display device 100 can be applied to a display apparatus in which corners are formed in a round shape.

Referring to FIGS. 4 and 5, the display device in accordance with one embodiment comprises a display area AA where a real image is displayed and a non-display area NA (i.e., a first non-display area NA1 or a second non-display area NA2) disposed outside of the display area AA.

A plurality of gate lines GL1 to GLm and a plurality of data lines DL1 to DLn are arranged in the display area AA to define the plurality of sub-pixels SP1, SP2 and SP3. In one embodiment, the sub-pixels SP1, SP2 and SP3 can comprise a red (R) sub-pixel, a green (G) sub-pixel and a blue (B) sub-pixel. Alternatively or additionally, the sub-pixel SP can further comprise a white (W) sub-pixel. In one embodiment, the sub-pixels SP1, SP2 and SP3 can form one pixel P.

Thin film transistors of a switching element and a display element for implementing a real image are disposed in each sub-pixel SP1, SP2 or SP3.

The display element can comprise various display elements. For example, the display element can comprise, but is not limited to, an organic light emitting display element, a liquid-crystal display element, a quantum-dot display element, a micro LED (light emitting diode) display element and a mini LED display element.

The display area AA can be divided into a first area A1, a second area A2 and a third area A3 along a first direction (horizontal direction, x-axis direction). In addition, in the case in which both side areas of the first area A1 are referred to as the second area, the second area A2 may be referred to as a left side second area, and the third area A3 may be referred to as a right side second area.

A plurality of first data lines DL1 and a plurality of vertical link lines VLINK are arranged along a second direction (vertical direction, y-axis direction) in the first area A1 of the display area AA. In this case, one first data line DL1 and one vertical link line VLINE correspond to one sub-pixel column arranged along the second direction. Each of the plurality of sub-pixels arranged in one sub-pixel column is electrically connected to corresponding one first data line DL1 to receive a data signal. In this case, the corresponding vertical link line VLINK is not electrically connected to the plurality of sub-pixels arranged in the sub-pixel column.

The second area A2 and the third area A3 of the display area AA are disposed on both sides of the first area A1. A plurality of second data lines DL2 and a plurality of third data lines DL3 extending in the second direction (vertical direction, y-axis direction) are arranged in the second area A2 and the third area A3, respectively. The vertical link line VLINK is not arranged in the second area A2 and the third area A3.

The plurality of first data lines DL1 disposed in the first area A1 are formed to have the same length from the lower end to the upper end of the circular display area AA. The length of the second data lines DL2 disposed in the second area A2 decreases from the central area toward the outside, that is, from the boundary of the first area A1 to the left end. In addition, the length of the third data line DL3 disposed in the third area A3 decreases from the central area toward the outside, that is, from the boundary of the first area A1 to the right end.

A plurality of horizontal link lines HLINK are arranged along the first direction (x-axis direction) in the first area A1, the second area A2 and the third area A3 of the display area AA. The plurality of horizontal link lines HLINK can be spaced apart from each other with the same separation distance, but is not limited thereto.

Each horizontal link line HLINK is electrically connected to the corresponding one vertical link line VLINK in the first area A1 through a first contact hole CNT1. Each horizontal link line HLINK, and second data line DL2 in the second area A2 and third data line DL3 in the third area A3 are disposed with an insulating layer therebetweeen, and are electrically connected through a second contact hole CNT2.

In FIG. 4, the plurality of vertical link lines VLINK and the plurality of horizontal link lines HLINK are disposed on one side of the sub-pixels SP1, SP2 and SP3. In another embodiment, the plurality of vertical link lines VLINK and the plurality of horizontal link lines HLINK may be disposed across the sub-pixels SP1, SP2 and SP3.

The leftmost vertical link line VLINK in the first area A1 can be electrically connected to the second data line DL2 closest arranged in second area A2, that is, the rightmost second data line DL2 in the second area A2, through the horizontal link line HLINK. In addition, the vertical link line VLINK disposed secondly from the leftmost side of the first area A1 may be electrically connected to the second data line DL2 disposed secondly from the rightmost side of the second area A2 through the horizontal link line HLINK, but is not limited thereto.

The rightmost vertical link line VLINK in the first area A1 can be electrically connected to the third data line DL3 closest arranged in the third area A3, that is, the leftmost third data line DL3 in the third area A3, through the horizontal link line HLINK. In addition, the vertical link line VLINK disposed secondly from the rightmost side of the first area A1 may be electrically connected to the third data line DL3 disposed secondly from the leftmost side of the third area A3 through the horizontal link line HLINK, but is not limited thereto.

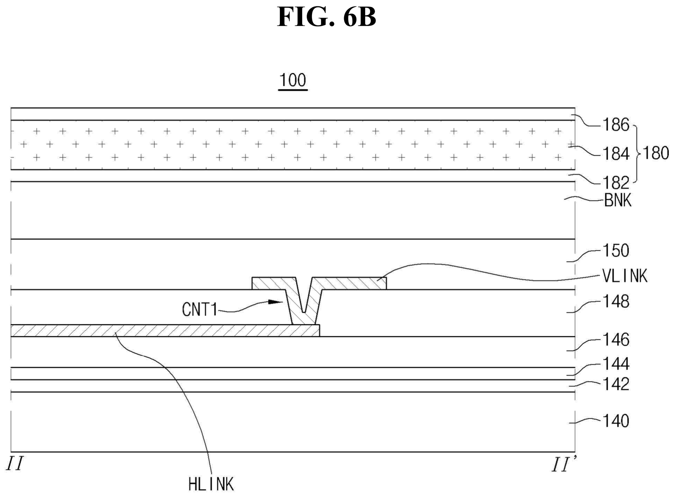

The gate driver 106 (FIG. 1) applying various signals to the sub-pixels SP1, SP2 and SP3 can be disposed in the first non-display area NA1 surrounding the display area AA. The gate driver 106 applies the scan signal to the sub-pixels SP1, SP2 and SP3 through the gate lines GL1 to GLm (FIG. 1). In one embodiment, the gate driver 106 can be a GIP circuit in which the gate driving circuits are directly disposed on the substrate 140 (FIGS. 6A and 6B).

A bending area BA extended from the first non-display area NA1 can be formed on a lower end of the first non-display area NA1. The bending area BA may be bent by bending in a certain direction. The second non-display area NA2 is an area extending form the bending area BA. A flexible circuit film FPC is attached to the second non-display area NA2.

Since the flexible circuit film FPC is disposed on a lower surface of the display device 100 by bending the bending area BA, the bezel of the display device 100 can be reduced.

A driving element DR is mounted on the flexible circuit film FPC and various lines are formed in the flexible circuit film FPC to supply data signals output from the driving element DR and various signals output from the outside to the display area AA. In one embodiment, the driving element DR can be directly mounted in the second non-display area NA2.

A plurality of data link lines DLINK and a plurality of signal link lines SLINK are disposed in the second non-display area NA2 and the bending area BA.

The plurality of data link lines DLINK are electrically connected to the plurality of first data lines DL1 in the first area A1, respectively. The plurality of signal link lines SLINK are electrically connected to the plurality of vertical link lines VLINK in the first area A1, respectively. The connection between the data link line DLINK and the first data line DL1, and the connection between the signal link line SLINK and the vertical link line VLINK can be performed through a pad electrode, respectively. Data signals are applied to the plurality of data link lines DLINK and the plurality of signal link lines SLINK, respectively.

Data signal is directly applied to the first data lines DL1 in the first area A1 of the display area AA through the data link lines DLINK to supply the data signal to the plural sub-pixels SP1, SP2 and SP3 of the sub-pixel column corresponding to the first area A1. Data signal is applied to the second data lines DL2 in the second area A2 of the display area AA through the signal link lines SLINK, the vertical link lines VLINK and the horizontal link lines HLINK to supply the data signal to the plural sub-pixels SP1, SP2 and SP3 of the sub-pixel column corresponding to the second area A2. Data signal is applied to the third data lines DL3 in the third area A3 of the display area AA through the signal link lines SLINK, the vertical link lines VLINK and the horizontal link lines HLINK to supply the data signal to the plural sub-pixels SP1, SP2 and SP3 of the sub-pixel column corresponding to the third area A3.

In the display device 100 of the present disclosure, the link lines supplying the data signal to the sub-pixels SP1, SP2 and SP3 in the second and third areas A2 and A3, each of which is disposed outside the first direction (width direction, x-axis direction) of the bending area BA and the second non-display area NA2, is not disposed in the non-display area NA, but is disposed in the display area AA, and therefore, it is possible to minimize the bezel area.

A compensation link line COLINK is formed to each of the plurality of vertical link lines VLINK. In one embodiment, the compensation link line COLINK may be formed by extending from the vertical link lines VLINK, respectively. Since the vertical link lines VLINK are extended from the lower end of the display area AA to the first contact hole CNT1, the compensation link lines COLINK can be formed by extending a predetermined distance ℓ along the second direction (y-axis direction) from the first contact hole CNT1.

In this way, the compensation link lines COLINK are formed by extending from the vertical link lines VLINK. This is to compensate for the storage capacity of the data lines DL to remove the deviation of the storage capacities between the data lines having different length.

In the free-form or non-rectangular display device 100, the length of the data lines DLs varies depending on the locations, and in particular, the data signal is applied to the sub-pixels SP1, SP2 and SP3 using the vertical link lines VLINK and the horizontal link lines HLINK, the storage capacity formed in the data lines DLs varies depending on the locations.

This difference in storage capacity is a major cause of deteriorating image quality by causing distortion in the displayed image. Various methods may be used to remove the difference in the storage capacity between the data lines DLs. For example, the storage capacity may be compensated by generating a parasitic capacity by forming a separate metal pattern in the first non-display area NA1. However, in this case, since the area of the first non-display area NA1 increases due to the metal pattern, there is a problem that the bezel area of the display device 100 increases.

In the present disclosure, it is possible to prevent an increase in the bezel area due to the separate metal pattern by arranging the compensation link lines COLINK in the display area AA.

The compensation link lines COLINK may be formed to extend from the vertical link lines VLINK. In one embodiment, the length ℓ of the compensation link line COLINK is inversely proportional to the lengths of the second data lines DL2 in the second area A2 and the third data lines DL2 in the third area A3.

The reason why the storage capacity deviation occurs in the second and third data lines DL2 and DL3 is that the lengths of the second and third data lines DL2 and DL2 are shorter than the length of the first data line DL1. Since the difference in storage capacity between the first data line DL1 and the second and third data lines DL2 and DL2 increases as the relative lengths of the second and third data lines DL2 and DL2 are shorter, the length ℓ of the compensation link line COLINK for compensating the storage capacity difference must be inversely proportional to the lengths of the second data line DL2 in the second area A2 and the third data line DL3 in the third area A3.

That is, the length of the compensation link line COLINK extended from the vertical link line VLINK connected to the shortest second data line DL2 and the third data line DL2 disposed at the outmost sides of the second area A2 and the third area A3, respectively, is the longest, and the lengths of the compensation link lines COLINK gradually decreases from the outmost sides of the second area A2 and the third area A3 to the first area A1 (i.e., as the lengths of the second data line DL2 and the third data line DL3 increase).

As described above, in the display device 100, the pattern for compensating for the variation in storage capacity due to the difference in length of the data lines DLs is not disposed in the non-display areas NA of the display device 100, but is disposed in the display area AA, thereby minimizing the bezel area.

Hereinafter, the configurations of the display device 100 will be described in more detail with reference to the accompanying drawings.

FIG. 6A illustrates a schematic cross-sectional view of the display device taken along a line I-I' in FIG. 4. FIG. 6B illustrates a schematic cross-sectional view of the display device taken along a line II-II' in FIG. 5.

Referring to FIGS. 6A and 6B, a buffer layer 142 is disposed on the substrate 140. In one embodiment, the substrate 140 can comprise a hard material such as glass. In another embodiment, the substrate can comprise, but is not limited to, a plastic material such as polyimide (PI), polymethyl methacrylate (PMMA), polyethylene terephthalate (PET), polyether sulfone (PES), polycarbonate (PC) and combinations thereof.

For example, when the substrate 140 includes polyimide, the substrate 140 can comprise multiple polyimide layers and an inorganic layer may be further disposed between the polyimide layers, but is not limited thereto.

The buffer layer 142 can be disposed on the entire substrate 140 to improve adhesion between layers disposed on the substrate 140 and the substrate 140, and to block alkaline components, etc. from leaking out from the substrate 140. In addition, the buffer layer 142 can delay the diffusion of moisture or oxygen that has penetrated into the substrate 140.

In one embodiment, the buffer layer 142 can comprise, but is not limited to, an inorganic insulating material such as silicon oxide (SiOx, wherein 0 < x ≤ 2)) and silicon nitride (SiNx, wherein 0 < x ≤ 2). The buffer layer 142 can have a single-layer structure or a multiple-layer structure. For example, the buffer layer 142 can have an alternate lamination structure of a layer of silicon nitride (SiNx) and a layer of silicon oxide (SiOx). In some embodiments, the buffer layer 142 can be omitted by the kinds and materials of the substrate 140 and the structure and/or the type of the thin film transistor.

A thin film transistor T is disposed on the buffer layer 142 in the display area AA. For the convenience of explanation, only the driving thin film transistor T among the various thin film transistors that can be arranged in the display area AA is illustrated in FIG. 6A, but other thin film transistor such as a switching thin film transistor may be disposed. In addition, the thin film transistor with a top gate structure is illustrated in FIG. 6A, the structure of the thin film transistor T is not limited thereto, and the thin film transistor T with other structures such as a bottom gate structure can be implemented.

The thin film transistor T can comprise a semiconductor layer 112 disposed on the buffer layer 142, a gate insulating layer 144 disposed on the semiconductor layer 112, a gate electrode 114 disposed on the gate insulating layer 144, an interlayer insulating layer 146 disposed on the gate electrode 114, and a source electrode 115 and a drain electrode 116 disposed on the interlayer insulating layer 146.

In one embodiment, the semiconductor layer 112 can comprise a polycrystalline semiconductor. For example, the polycrystalline semiconductor can comprise, but is not limited to, low temperature poly silicon (LTPS) with high mobility.

In another embodiment, the semiconductor layer 112 can comprise an oxide semiconductor. For example, the oxide semiconductor can comprise, but is not limited to, indium-gallium-zinc oxide (IGZO), indium-zinc oxide (IZO), indium-gallium-tin oxide (IGTO), indium-gallium oxide (IGO) and combinations thereof. In some embodiments, the semiconductor layer 112 can comprise a channel area 112a of the central area, and a source area 112b and a drain area 112c as the doping areas on both sides of the channel areal 112a.

In one embodiment, the gate insulating layer 144 can be arranged in the display area AA and the non-display areas NA. In another embodiment, the gate insulating layer 144 can be arranged only in the display area AA. For example, the gate insulating layer 144 can comprise an inorganic insulating material such as silicon oxide (SiOx, wherein 0 < x ≤ 2) and silicon nitride (SiNx, wherein 0 < x ≤ 2). The gate insulating layer 144 can have a single-layer structure or a multiple-layer structure. But embodiments of the present disclosure are not limited thereto.

In one embodiment, the interlayer insulating layer 146 can be arranged in the display area AA and the non-display area NA. In another embodiment, the interlayer insulating layer 146 can be arranged only in the display area AA. For example, the interlayer insulation layer 146 can comprise, but is not limited to, an organic material such as photo-acryl or an inorganic insulating material such as silicon oxide (SiOx, wherein 0 < x ≤ 2) and silicon nitride (SiNx, wherein 0 < x ≤ 2). The interlayer insulating layer 146 can have a single-layer structure or a multiple-layer structure. In another embodiment, the interlayer insulating layer 146 can have a multi-layer structure with at least one organic layer and at least one inorganic layer. But embodiments of the present disclosure are not limited thereto.

In one embodiment, each of the source electrode 115 and the drain electrode 116 can comprise, but is not limited to, molybdenum (Mo), aluminum (Al), chrome (Cr), gold (Au), titanium (Ti), nickel (Ni), neodymium (Nd), copper (Cu), combinations thereof, or alloys thereof. Each of the source electrode 115 and the drain electrode 116 can have a single-layer structure of a multi-layer structure. But embodiments of the present disclosure are not limited thereto. The source electrode 115 and the drain electrode 116 can be contacted to the source area 112b and the drain area 112c of the semiconductor layer 112, respectively, through contact holes formed in the gate insulating layer 144 and/or the interlayer insulating layer 146.

The horizontal link line HLINK is disposed on the interlayer insulating layer 146. In one embodiment, the horizontal link line HLINK can comprise the same material as the source electrode 115 and the drain electrode 116, but is not limited thereto.

In some embodiments, a bottom shield metal layer can be disposed between the substrate 140 and the semiconductor layer 112. The bottom shield metal layer may be arranged to minimize the back channel phenomenon caused by charges trapped in the substrate 140 and to prevent afterimages or performance degradation of the transistor. For example, the bottom shield metal layer can comprise, but is not limited to, titanium (Ti), molybdenum (Mo) and alloys thereof. The bottom shield metal layer can have a single-layer structure or a multi-layer structure.

A first planarization layer 148 is disposed on the substrate 140 where the thin film transistor T is disposed. In one embodiment, the first planarization layer 148 can comprise, but is not limited to, an organic material such as photo-acryl. In another embodiment, the first planarization layer 148 can have a multi-layer structure with at least one inorganic layer and at least one organic layer.

A connection pattern 154 is disposed on the first planarization layer 148. The connection pattern 154 can be electrically connected to one of the source electrode 115 and the drain electrode 116 of the thin film transistor T through a contact hole formed in the first planarization layer 148. For example, the connection pattern 154 can comprise a metallic component.

The vertical link line VLINK is disposed on the first planarization layer 148. In one embodiment, the vertical link line VLINK can comprise, but is not limited to, the same metallic component as the connection pattern 154. The vertical link line VLINK can be electrically connected to the horizontal link line HLINK through the first contact hole CNT1 formed in the first planarization layer 148.

In FIGS. 6A and 6B, the horizontal link line HLINK is disposed on the interlayer insulating layer 146 and the vertical link line VLINK is disposed on the first planarization layer 148. In another embodiment, the vertical link line VLINK can be disposed on the interlayer insulating layer 146 and the horizontal link line HLINK can be disposed on the first planarization layer 148.

A second planarization layer 150 is disposed on the first planarization layer 148 where the connection pattern 154 and the vertical link line VLINK are disposed. In one embodiment, the second planarization layer 150 can comprise, but is not limited to, an organic material such as photo-acryl. In another embodiment, the second planarization layer 150 can have a multi-layer structure with at least one inorganic layer and at least one organic layer. In one embodiment, the second planarization layer 150 can comprise a same material as the first planarization layer 148. In another embodiment, the second planarization layer 150 can comprise a different material from the first planarization layer 148.

It is possible to dispose various electrodes and lines between the first planarization layer 148 and the second planarization layer 150 by arranging two or more planarization layers 148 and 150. In this case, since the electrodes can be arranged vertically, the area occupied by the electrodes and lines in the sub-pixels can be reduced. Therefore, it is possible to reduce the area of the sub-pixels and to manufacture the display device 100 with a high resolution.

A light-emitting diode (or light-emitting element) D is disposed on the second planarization layer 150 in the display area AA. The light-emitting diode D can comprise a first electrode 132, an emissive layer 134 and a second electrode 136 each of which disposed sequentially on the second planarization layer 150.

The first electrode 132 is disposed on the second planarization layer 150. The first electrode 132 can be electrically connected to the connection pattern 154 through a contact hole formed in the second planarization layer 150. In other words, the first electrode 132 can be electrically connected to one of the source electrode 115 or the drain electrode 116 of the thin film transistor T through the connection pattern 154.

For example, the first electrode 132 can comprise, but is not limited to, a metallic component such as silver (Ag), aluminum (Al), molybdenum (Mo), tungsten (W), chrome (Cr), combinations thereof or alloys thereof. In another embodiment, the first electrode 132 can comprise, but is not limited to, a transparent metal oxide such as indium-tin oxide (ITO) and/or indium-zinc oxide (IZO).

In one embodiment, when the display device 100 is a top-emission type, the first electrode 132 can further comprise an opaque conductive material acting as a reflection electrode. In another embodiment, when the display device 100 is a bottom-emission type, the first electrode 132 can be disposed using the transparent conductive material such as ITO and/or IZO.

A bank layer BNK is disposed on the second planarization layer 150 at the boundary of each sub-pixel. The bank layer BNK can be a kind of a partitioned wall defining each sub-pixel. The bank layer BNK partitions each sub-pixel and can prevent light of a specific color output from adjacent sub-pixels from being mixed and output.

For example, the bank layer BNK can comprise, but is not limited to, an inorganic material such as silicon oxide (SiOx, wherein 0 < x ≤ 2) and silicon nitride (SiNx, wherein 0 < x ≤ 2), an organic material such as benzocyclobutene (BCB), an acryl-containing resin, an epoxy-containing resin, a phenol-containing resin, a polyamide-containing resins and/or a polyimide-containing resin, a photo-sensitive agent containing a black pigment and/or dye, and combinations thereof.

The emissive layer 134 can be arranged on the first electrode 132, an inclined surface of the bank layer BNK and on a portion of the bank layer BNK in the display area AA, and extend to the non-display areas NA.

In one embodiment, the emissive layer 134 can comprise, but is not limited to, a red emissive layer emitting red color light and disposed in the red sub-pixel, a green emissive layer emitting green color light and disposed in the green sub-pixel and a blue emissive layer emitting blue color light and disposed in the blue sub-pixel. For example, the emissive layer 134 can comprise, but is not limited to, an organic emissive layer, or an inorganic emissive layer such as a nano-sized material layer, quantum dots, a micro LED emissive layer or a mini LED emissive layer.

In one embodiment, the emissive layer 134 can comprise an emitting material layer. In another embodiment, the emissive layer 134 can further comprise a hole injection layer, a hole transport layer, and/or an electron blocking layer disposed between the first electrode 132 and the emitting material layer, and an electron injection layer, an electron transport layer and/or a hole blocking layer disposed between the emitting material layer and the second electrode 136.

The second electrode 136 is disposed on the emissive layer 134. In one embodiment, the second electrode 136 can have a single-layer structure or a multi-layer structure with a metallic component or alloys thereof. In another embodiment, the second electrode 136 can comprise a transparent metal oxide such as ITO and/or IZO. But embodiments of the present disclosure are not limited thereto.

In one embodiment, when the display device 100 is a top-emission type, the second electrode 136 can be arranged using the transparent or semi-transparent conductive material. For example, the second electrode 136 can comprise, but is not limited to, an alloy such as LiF/Al, CsF/Al, Mg:Ag, Ca/Ag, Ca:Ag, LiF/Mg:Ag, LiF/Ca/Ag, LiF/Ca:Ag and combinations thereof.

In another embodiment, when the display device 100 is a bottom-emission type, the second electrode 136 can be arranged using an opaque conductive material. For example, the second electrode 136 can comprise, but is not limited to, silver (Ag), aluminum (Al), gold (Au), molybdenum (Mo), tungsten (W), chrome (Cr) and/or alloys thereof.

In another embodiment, the light-emitting diode D can have a tandem structure. The tandem structure includes a plurality of emitting parts and at least one charge generation layers disposed between the emitting parts. The charge generation layer is intended to connecting the plural emitting parts. In one embodiment, a plurality of charge generation layers including a first charge generation layer and a second charge generation layer can be disposed. In one embodiment, the charge generation layer can include an N-type charge generation layer and a P-type charge generation layer. For example, the charge generation layer can comprise, but is not limited to, an organic layer doped with alkali metal such as Li, Na, K and/or Cs and/or alkaline earth metal such as Mg, Sr, Ba and/or Ra.

An encapsulation layer 180 is disposed in the display area AA and the non-display areas NA to encapsulate the light-emitting diode D. When the light-emitting diode D is exposed to moisture or oxygen, a pixel shrinkage phenomenon in which the light emission area shrinks or a defect in which a dark spot is formed within the light emission area may occur. In addition, the moisture or oxygen may oxidize the electrode made of the metallic component. The encapsulation layer 180 blocks the penetration of moisture and oxygen from the outside to prevent defects in the light-emitting diode D and various electrodes.

In one embodiment, the encapsulation layer 180 can comprise, but is not limited to, a first encapsulation layer 182, a second encapsulation layer 184 and a third encapsulation layer 186. In another embodiment, the encapsulation layer 180 can comprise two layers or four or more layers.

In one embodiment, each of the first encapsulation layer 182 and the third encapsulation layer 186 can comprise an inorganic material such as silicon oxide (SiOx, wherein 0 < x ≤ 2) and silicon nitride (SiNx, wherein 0 < x ≤ 2). Each of the first encapsulation layer 182 and the third encapsulation layer 186 can have a single-layer structure or a multi-layer structure. In another embodiment, each of the first encapsulation layer 182 and the third encapsulation layer 186 can further comprise at least one organic layer disposed between the inorganic layers. The second encapsulation layer 184 can comprise an epoxy-containing resin. But the embodiments of the present disclosure are not limited thereto.

While not shown in FIGS. 6A and 6B, a touch member can be disposed on the encapsulation layer 180. The touch member can be disposed in the display area AA and sense the touch input. The touch member can sense outer touch information using user's finger or a touch pen.

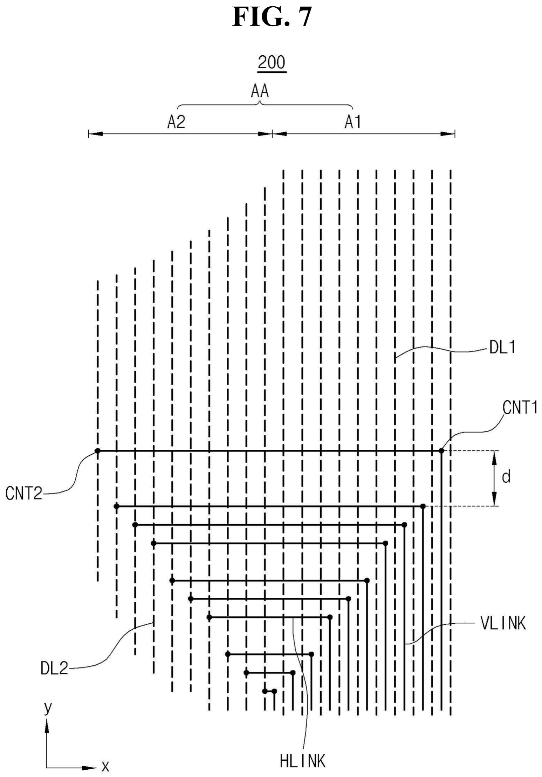

FIG. 7 illustrates line arrangements in the display area AA of the display device 200 in accordance with another embodiment of the present disclosure. In the display device 200 in this embodiment, only the arrangements of the horizontal link line HLINK and the vertical link line VLINK are different from those of the display device 100 in the first embodiment and other configurations are the same as those of the display device 100, and thus only the arrangements of the horizontal link line HLNIK and the vertical link line VLINK are illustrated in FIG. 7. In particular, the second area and third areas disposed on both sides of the first area A1 of the display area AA are symmetrical with respect to the first area A1, so that the arrangements of the horizontal link line HLINK and the vertical link line VLINK in the second and third areas are identical to each other. Therefore, for the convenience of description, only the first area A1 and the second area A2 of the display area AA are illustrated in FIG. 7.

Referring to FIG. 7, a plurality of first data lines DL1 and a plurality of vertical link lines VLINK are disposed along the second direction (vertical direction, y-axis direction) in the first area A1 of the display area AA in the display device 200. A plurality of second data lines DL2 extending in the second direction are disposed in the second area A2 of the display area AA. In this embodiment, the vertical link line VLINK is not disposed in the second area A2.

All the plurality of first data lines DL1 disposed in the first area A1 are formed to have the same length from the lower end to the upper end of the display area AA. On the contrary, the length of the plurality of second data lines DL2 disposed in the second area A2 decreases from the central area to the outside, that is, from the boundary of the first area A1 to the left end.

The plurality of horizontal link lines HLINK are disposed in the first direction (horizontal direction, x-axis direction) in the first area A1 and the second area A2 of the display area AA.

The horizontal link lines HLINK are electrically connected to the vertical link lines VLINK in the first area A1 through the first contact hole CNT1, respectively. The horizontal link line HLINK and the second data line DL2 are formed with an insulating layer therebetween to be electrically connected to each other through the second contact hole CNT2.

The leftmost vertical link line VLINK in the first area A1 can be electrically connected to the second data line DL2 closest arranged in the second area A2, that is, the rightmost second data line DL2 in the second area A2, through the horizontal link line HLINK. In addition, the second vertical link line VLINK disposed secondly from the leftmost side of the first area A1 may be electrically connected the second data line DL2 disposed secondly from the rightmost side of the second area A2 through the horizontal link line HLINK, but is not limited thereto.

The data signal is directly applied to each of the first data lines DL1 in the first area A1 of the display area AA to supply the data signal to the plurality of sub-pixels SP1, SP2 and SP3 of the corresponding sub-pixel column in the first area A1. The data signal is applied to each of the second data lines DL2 in the second area A2 of the display area AA through the vertical link line VLINK and the horizontal link line HLINK to supply the data signal to the plurality of sub-pixels SP1, SP2 and SP3 corresponding to the sub-pixel column in the second area A2.

In the display device 200 of the present disclosure, the bezel area can be minimized by arranging the link lines for supplying the data signal to the sub-pixels SP1, SP2 and SP3 in the display area AA disposed outside the first direction, which is the width direction of the bending area BA and the second non-display area NA2 (FIG. 4), in the display area AA rather than the non-display area NA (FIG. 4).

In one embodiment, the plurality of horizontal link lines HLINK disposed in the display area DA are not disposed at equal separation distance in accordance with the display device 200. In the free-form or non-rectangular-shaped display device 200, since the difference in storage capacity occurs between the data lines DLs having different lengths, the difference in storage capacity is compensated by varying the lengths of the vertical link lines VLINK connected to data lines DLs depending on the lengths of the data lines DLs.

That is, the difference in storage capacity may be compensated by setting the length of the vertical link line inversely proportional to the length of the second data line DL2. For example, the length of the vertical link line VLINK connected to the second data line DL2 disposed at the outmost portion in the second area A2 is the longest, and the length of the vertical link line VLINK gradually decreases from the outmost portion of the second area A2 to the first area A1.

In other words, the difference in storage capacity may be compensated by increasing the distance "d" between the horizontal link lines HLINK, which is connected to the vertical link line VLINK and the second data line DL2, depending on the length of the second data line DL2. For example, the difference in storage capacity can be compensated by adjusting the distance "d' between the horizontal link lines HLINK, each of which is electrically connected to the corresponding second data line DL2, as the length of plurality of second data lines DL2 decreases.

While a circular display device is applied to a watch or like as the free-from or non-rectangular-shaped display device in the above description, the present disclosure is not limited to a display device having such a specific shape. In one embodiment, the first area A1 may be a rectangular-shaped area and the second area A2 may be a non-rectangular-shaped (circular shaped) area, but is not limited thereto.

The present disclosure may be applied to a display device having various shapes other than a square or a rectangular shape or a display device having a partial area with the free-form or the non-rectangular shape. For example, when some areas have a free-from or non-rectangular shape, the length of the data line in the free-form area is reduced, and the storage capacity of the data lines in the free-form or non-rectangular area can be compensated by the horizontal link lines and the vertical link lines disposed in the free-form area. In one embodiment, the first area A1 may be a rectangular-shaped area and the second area A2 may be a non-rectangular-shaped area, but is not limited thereto.

It will be apparent to those skilled in the art that various modifications and variations can be made in the present disclosure without departing from the scope of the disclosure. Thus, it is intended that the present disclosure cover the modifications and variations of the present disclosure provided they come within the scope of the appended claims and the equivalent thereof.

## Claims

1. A display device, comprising:
a display panel (109) including a first area (A1) and at least one second area (A2);
a plurality of gate lines (GL1) arranged in a first direction (x) in the first area (A1) and the at least one second area (A2);
a plurality of first data lines (DL1) arranged in a second direction (y) perpendicular to the first direction (x) in the first area (A1);
a plurality of second data lines (DL2) arranged in the second direction (y) in the at least one second area (A2) and having a length shorter than a length of the plurality of first data lines (DL1);
a plurality of vertical link lines (VLINK) arranged in the second direction (y) in the first area (A1); and
a plurality of horizontal link lines (HLINK) arranged in the first direction (x) in the first area (A1) and the at least one second area (A2),
wherein each of the plurality of vertical link lines (VLINK) is electrically connected to a corresponding one second data line (DL2) through a corresponding one horizontal link line (HLINK), and
wherein each of the plurality of vertical link lines (VLINK) has a length inversely proportional to a length of a respective one of the plurality of second data lines (DL2) to be connected.

2. The display device of claim 1, wherein a data signal is directly applied to each of the plurality of first data lines (DL1), and the data signal is applied to each of the plurality of second data lines (DL2) through a respective one of the plurality of vertical link lines (VLINK) and a respective one of the plurality of horizontal link lines (HLINK).

3. The display device of claim 1 or 2, further comprises:
a first contact hole (CNT1) electrically connecting each of the plurality of vertical link lines (VLINK) to the corresponding one horizontal link line (HLINK); and
a second contact hole (CNT2) electrically connecting each of the plurality of horizontal link lines (HLINK) to the corresponding one second data line (DL2), optionally,
a thin film transistor (T) disposed in the first area (A1) and the at least one second area (A2), respectively; and
a light emitting diode (D) disposed on the thin film transistor (T).

4. The display device of claim 3, wherein the thin film transistor (T) comprises:
a semiconductor layer (112) disposed on a substrate (140);
a gate electrode (114) disposed on the semiconductor layer (112); and
a source electrode (115) and a drain electrode (116) disposed on the gate electrode (114), the display device further comprising:
a gate insulating layer (144) disposed between the semiconductor layer (112) and the gate electrode (114);
an interlayer insulating layer (146) disposed between the gate electrode (114), and the source electrode (115) and the drain electrode (116);
a planarization layer (148) disposed on the source electrode (115) and the drain electrode (116); and
a connection pattern (154) disposed on the planarization layer (148) and connected to one of the source electrode (115) and the drain electrode (116).

5. The display device of claim 4, wherein the plurality of vertical link lines (VLINK) are arranged on the planarization layer (148), and the plurality of horizontal link (HLINK) lines are arranged on the interlayer insulating layer (146).

6. The display device of claim 4 or 5, wherein the plurality of vertical link lines (VLINK) comprise a same material as the connection pattern (154) and/or the plurality of horizontal link lines comprise a same material as the source electrode (115) and the drain electrode (116).

7. The display device of any one of the preceding claims 5 or 6, wherein each of the plurality of vertical link lines (VLINK) is electrically connected to the corresponding one horizontal link line (HLINK) through the first contact hole (CNT1) disposed in the planarization layer (148).

8. The display device of any one of the preceding claims, wherein each of the plurality of vertical link lines (VLINK) extends a predetermined distance from the first contact hole (CNT1), and the predetermined distance of each of the plurality of vertical link lines (VLINK) is inversely proportional to the length of the respective one of the plurality of second data lines (DL2) to be connected.

9. The display device of any one of the preceding claims, wherein a distance (d) between the plurality of horizontal link lines (HLINK) connected to the plurality of second data lines (DL2) increases as the length of the plurality of second data lines (DL2) decreases.

10. The display device of any one of the preceding claims, wherein the display panel (109) has a free form or a circular shape, and/or the first area (A1) is a rectangular-shaped area, and the at least one second area (A2) is a non-rectangular-shaped area, and/or the first area (A1) is a central area of the circular shape, and the at least one second area (A2) is both side areas of the central area.

11. The display device of any one of the preceding claims, wherein the plurality of vertical link lines (VLINK) are not arranged in the at least one second area (A2).

12. The display device of any one of the preceding claims, wherein the plurality of first data lines (DL1) are formed to have a same length.

13. A display device, comprising:
a display panel (109) including a first area (A1) and at least one second area (A2);
a plurality of gate lines (GL) arranged in a first direction (x) in the first area (A1) and the at least one second area (A2);
a plurality of first data lines (DL1) arranged in a second direction (y) perpendicular to the first direction in the first area (A1);
a plurality of second data lines (DL2) arranged in the second direction (y) in the at least one second area (A2) and having a length shorter than a length of the plurality of first data lines (DL1);
a plurality of vertical link lines (VLINK) arranged in the second direction (y) in the first area (A1);
a plurality of horizontal link lines (HLINK) arranged in the first direction (x) in the first area (A1) and the at least one second area (A2); and
a plurality of compensation link lines (COLINK) extended from the plurality of vertical link lines (VLINK), respectively,
wherein each of the plurality of vertical link lines (VLINK) is electrically connected to a corresponding one second data line (DL2) through a corresponding one horizontal link line (HLINK), and
wherein each of the plurality of compensation link lines (COLINK) has a length inversely proportional to a length of a respective one of the plurality of second data lines (DL2) to be connected.

14. A display device, comprising:
a display panel (109) including a first area (A1) and at least one second area (A2);
a plurality of gate lines (GL) arranged in a first direction (x) in the first area (A1) and the at least one second area (A2);
a plurality of first data lines (DL1) arranged in a second direction (y) perpendicular to the first direction in the first area (A1);
a plurality of second data lines (DL2) arranged in the second direction (y) in the at least one second area (A2) and having a length shorter than a length of the plurality of first data lines (DL1);
a plurality of vertical link lines (VLINK) arranged in the second direction (y) in the first area (A1); and
a plurality of horizontal link lines (HLINK) arranged in the first direction (x) in the first area (A1) and the at least one second area (A2),
wherein a distance between the plurality of horizontal link lines (HLINK) is inversely proportional to a length of a respective one of the plurality of second data lines (DL2) to which a respective one of the plurality of horizontal link lines (HLINK) is connected.
